# EUROPÄISCHE PATENTSCHRIFT

(11) **EP 3 401 950 B1**
(45) Veröffentlichungstag und Bekanntmachung des Hinweises auf die Patenterteilung: **03.11.2021**
(21) Anmeldenummer: 18177442.3
(22) Anmeldetag: 21.09.2006
(51) Int. Cl.: H01L 21/48, B23K 20/10, H05K 3/32, H01L 25/07, H05K 1/03, H05K 3/40, B23K 101/40

(54) **VERFAHREN ZUR HERSTELLUNG EINES LEISTUNGSHALBLEITERMODULS**
METHOD OF MANUFACTURING A POWER SEMICONDUCTOR MODULE
PROCÉDÉ DE FABRICATION D'UN MODULE SEMICONDUCTEUR DE PUISSANCE

(30) Priorität: 21.09.2005 DE 102005045100
(43) Veröffentlichungstag der Anmeldung: 14.11.2018
(62) Teilanmeldung aus: 06805805.6
(73) Patentinhaber: Infineon Technologies AG, 85579 Neubiberg (DE)
(72) Erfinder: Kemper, Alfred, 59581 Warstein (DE); Strotmann, Guido, 59609 Anroechte (DE)
(74) Vertreter: Westphal, Mussgnug & Partner, Patentanwälte mbB

(56) Entgegenhaltungen:
- EP-A- 0 523 547
- DE-A1- 4 301 692
- DE-A1- 10 157 362
- JP-A- 2000 232 189
- JP-A- 2002 164 461
- JP-A- 2002 313 851
- JP-A- 2003 188 310
- JP-A- 2003 198 077
- US-A- 3 507 033
- US-A- 5 277 356

## Beschreibung

Vorgeschlagen werden ein Leistungshalbleitermodul und ein Verfahren zu dessen Herstellung. Vorgeschlagen werden insbesondere das Verbinden von Stromabnahmen oder Stromanschlüssen in Leistungshalbleitermodulen mittels Ultraschallschweißen.

Beim Aufbau moderner Leistungshalbleitermodule werden zur Kontaktierung von Abschnitten einer zugrunde liegenden Leistungshalbleiterschaltung oder zu deren Kontaktierung nach außen Kontaktbereiche mit Kontaktelementen, z.B. mit bandförmigen Stromabnahmen oder Stromanschlüssen mit oder aus z.B. Kupfer, kontaktiert und verbunden. Kontakte werden dabei auf der Grundlage von Verbindungen ausgebildet, die eine vergleichsweise beschränkte Betriebstemperatur voraussetzen. Diese liegt z.B. unterhalb von 125°C. Selbst bei der Verbesserung entsprechender Lötverbindungen ist diese Betriebstemperaturgrenze nach oben hin kaum weiter auszubauen.

Die Druckschrift JP 2003 188310 A offenbart ein Keramiksubstrat, das hauptsächlich aus einem Aluminiumnitrid oder einem Siliziumnitrid besteht. Auf das Substrat wird (a) ein Kupferkreis oder eine Kupferplatte unter Verwendung eines Silber-, Kupfer-, Zinn- und Zirkonium-Lötmaterials verbunden und das Lötmaterial wird unter einer Stickstoffatmosphäre erhitzt oder (b) eine Al- oder Al-Legierungsschaltung oder eine Al- oder Al-Legierungsplatte wird gebondet unter Verwendung mindestens einer Art von Bindungsmaterial, ausgewählt aus einer Legierungsfolie auf Al-Cu-Basis, einem Pulver der Legierungsfolie auf Al-Cu-Basis, und einem gemischten Pulver das Al und Cu enthält, und das Bondmaterial wird unter der Stickstoffatmosphäre erhitzt. Wenn die Kupferplatte oder die Al- oder Al-Legierungsplatte mit dem Keramiksubstrat verbunden sind, wird der Kupferkreislauf oder der Al- oder Al-Legierungskreislauf durch Ätzen der Platte gebildet. Danach werden die Elektrodenanschlüsse an einem Teil der Schaltung mit einer Fläche von ≤ 1/3 der Schaltung angebracht, wobei die Fläche jedes Anschlusses 3 bis 30 mm² beträgt, indem den darunter liegenden Anschlüssen unter einer bestimmten Bedingung Ultraschallenergie verliehen wird.

Es sollen Leistungshalbleitermodule und Verfahren zu deren Herstellung angegeben werden, bei welchen auf besonders einfache und doch zuverlässige Art und Weise entsprechende Kontakte mit erweiterten Betriebstemperaturbereichen ausgebildet werden können.

Dies wird durch ein Verfahren zum Herstellen eines Leistungshalbleitermoduls mit den Merkmalen des unabhängigen Patentanspruchs 1 gelöst. Weiterbildungen des Herstellungsverfahrens für Leistungshalbleitermodule sind Gegenstand der abhängigen Ansprüche.

Ein Aspekt besteht im allgemeinsten Sinn darin, bei einem Herstellungsverfahren für Leistungshalbleitermodule auszubildende Kontakte durch Ultraschallschweißen auszubilden, indem eine Sonotrode, die für den Ultraschallschweißvorgang verwendet wird, auch zum Fügen der Kontaktbereiche mit den Kontaktenden und mithin zum Fügen der Kontakte und der Fußbereiche verwendet wird.

Diese und weitere Aspekte werden auch anhand schematischer Zeichnungen näher erläutert:
Fig. 1A zeigt in schematischer und geschnittener Seiten Ansicht eine Ausführungsform eines Leistungshalbleitermoduls, die nicht durch die beanspruchte Erfindung abgedeckt ist
Figur 1B-D zeigen schematische Ansichten weitere Ausführungsformen des Leistungshalbleitermoduls, die nicht durch die beanspruchte Erfindung abgedeckt sind.
Figur 2 zeigt in schematischer Draufsicht die Ausführungsform eines Leistungshalbleitermoduls gemäß Fig. 1A, die nicht durch die beanspruchte Erfindung abgedeckt ist.
Fig. 3 zeigt in schematischer und geschnittener Seitenansicht ein Detail einer anderen Ausführungsform des Leistungshalbleitermodduls, die nicht durch die beanspruchte Erfindung abgedeckt ist.
Fig. 4 zeigt in schematischer und geschnittener Seitenansicht ein Detail einer anderen Ausführungsform des Leistungshalbleitermoduls, die nicht durch die beanspruchte Erfindung abgedeckt ist.
Fig. 5A - 5D zeigen in schematischer und geschnittener Seitenansicht Zwischenstufen, die bei einer Ausführungsform des hergestellten Verfahrens zum Herstellen eines Leistungshalbleitermoduls erreicht werden. Diese Ausführungsform ist lediglich als Beispiel zu betrachten, das das Verständnis der Erfindung erleichtert.

Nachfolgend werden funktionell und/oder strukturell ähnliche oder vergleichbare Elemente mit denselben Bezugszeichen bezeichnet, ohne dass in jedem Fall ihres Auftretens eine detaillierte Beschreibung erfolgt oder wiederholt wird. Die zuvor und nachfolgend genannten Aspekte, Eigenschaften und technischen Merkmale können in beliebiger Kombination miteinander vorgesehen werden.

Es wird ein Verfahren zum Herstellen eines Leistungshalbleitermoduls vorgeschlagen, bei welchem eine Leistungshalbleiterschaltung zu deren elektrischer Kontaktierung mit mindestens einem ersten Kontaktbereich ausgebildet wird, bei welchem zur elektrischen Kontaktierung der Leistungshalbleiterschaltung ferner ein Kontaktelement mit mindestens einem ersten Kontaktende ausgebildet wird, bei welchem mindestens das erste Kontaktende mit dem ersten Kontaktbereich zu einem ersten Kontakt mechanisch und elektrisch verbunden wird und bei welchem ein jeweiliger Kontakt mittels Ultraschallschweißen ausgebildet wird, indem eine Sonotrode, die für den Ultraschallschweißvorgang verwendet wird, auch zum Fügen der Kontaktende mit den Kontaktbereichen und mithin zum Fügen der Kontakte verwendet wird, wobei als Kontaktelemente massive kupferne oder primär Kupfer enthaltende Stromabnahmen verwendet werden mit einer Materialstärke im Bereich von etwa 0,1 mm bis etwa 3,0 mm und mit einer Stromtragfähigkeit im Bereich von etwa 50 A bis etwa 2000 A, wobei zumindest ein Teil der Kontaktbereiche von einem DCB-Substrat mit einer kupfernen oder primär Kupfer enthaltenden Schicht mit einer Materialstärke im Bereich von etwa 0,1 mm bis etwa 1,0 mm gebildet wird, wobei eine Ultraschallschweißleistung im Bereich von etwa 300 W bis etwa 10 kW verwendet wird und wobei als Fügekraft eine Normalkraft auf oder für die Sonotrode im Bereich von etwa 500 N bis etwa 3500 N verwendet wird ; bei welchem vor dem eigentlichen Ultraschallschweissvorgang die Sonotrode auf den Kontaktbereich abgesenkt wird, so dass dadurch das jeweilige Kontaktende unter Kraft oder Druck auf die Oberfläche des jeweiligen Kontaktbereichs angedrückt wird, und die Sonotrode erst nach dem Andrücken des jeweiligen Kontaktendes an den Kontaktbereich aktiviert wird; und bei welchem in der Nachbarschaft zu Kantenbereichen der Kontaktbereiche beim Ultraschallschweißen eine Schweißrichtung und/oder Schwingungsrichtung verwendet wird, die im Wesentlichen parallel zur Richtung des jeweiligen Kantenbereichs verläuft, um ein Ablösen des Kontaktbereichs am DCB-Substrat zu vermeiden.

Die Oberflächen der Stromabnahmen oder Stromanschlüsse und der Substrate können mit oder aus Cu, Ni, NiPdAu, Pd, Ag, Sn, Zn und/oder Al ausgebildet sein.

Es können Stromabnahmen verwendet werden mit einer Materialstärke im Bereich von etwa 0,8 mm bis etwa 1,5 mm.

Es können Stromabnahmen verwendet werden mit einer Stromtragfähigkeit im Bereich von etwa 300 A bis etwa 2000 A, vorzugsweise im Bereich von etwa 300 A bis etwa 1000 A.

Es kann ein DCB-Substrat mit einer kupfernen oder primär Kupfer enthaltenden Schicht mit einer Materialstärke im Bereich von etwa 0,25 mm bis etwa 0,6 mm verwendet werden.

Die Ultraschallschweißleistung kann im Bereich von etwa 500 W bis etwa 2 kW liegen.

Die Frequenz für das Ultraschallschweißen kann im Bereich von etwa 20 kHz bis etwa 35 kHz liegen.

Die Energie für das Ultraschallschweißen kann im Bereich von etwa 50 Ws bis etwa 3 kWs liegen, vorzugsweise im Bereich von etwa 50 Ws bis etwa 800 Ws.

Die Amplitude für das Ultraschallschweißen kann im Bereich von etwa 15 µm bis etwa 50 µm liegen, vorzugsweise im Bereich von etwa 25 µm bis etwa 35 µm.

Die Schweißzeit für das Ultraschallschweißen kann im Bereich von etwa 50 ms bis etwa 2000 ms liegen, vorzugsweise im Bereich von etwa 100 ms bis etwa 500 ms.

Die ersten Kontaktenden der Kontaktelemente können mit Energierichtungsgebern in Form von Erhebungen an den ersten Kontaktenden zur besseren Kraftausrichtung beim Ultraschallschweißen ausgebildet werden.

Die Energierichtungsgeber können eine Materialstärke im Bereich von etwa 0,05 mm bis etwa 0,50 mm aufweisen, vorzugsweise im Bereich von etwa 0,10 mm bis etwa 0,20 mm.

Die Energierichtungsgeber können einen Durchmesser im Bereich von etwa 0,5 mm bis etwa 4,0 mm aufweisen, vorzugsweise im Bereich von etwa 1,0 mm bis etwa 1,5 mm.

Die Energierichtungsgeber können eine Fläche im Bereich von etwa 0,2 mm² bis etwa 12,5 mm² aufweisen, vorzugsweise im Bereich von etwa 0,8 mm² bis etwa 1,8 mm².

Es kann vor dem eigentlichen Ultraschallschweißvorgang ein Vorgang des Kalibrierens durchgeführt werden, bei welchem mittels der Sonotrode simultan Druck auf eine Mehrzahl Kontaktenden ausgeübt wird, bis sämtliche Energierichtungsgeber mechanisch kontaktiert sind.

Das Ultraschallschweißen kann als simultaner Mehrfachschweißvorgang durchgeführt werden, bei welchem simultan eine Mehrzahl Kontaktelemente über Mehrzahl Kontaktenden kontaktiert werden, insbesondere mit jeweils einer Stromtragfähigkeit im Bereich von etwa 50 A bis etwa 500 A.

Ferner ist es zusätzlich denkbar, dass ein jeweiliges Kontaktelement zunächst mittels einer Halte- und Positioniervorrichtung gehaltert und positioniert wird und dann mittels der Sonotrode das Fügen und Fixieren erfolgt.

Ferner ist es bei einer Fortentwicklung des Verfahrens zum Herstellen eines Leistungshalbleitermoduls vorgesehen, dass ein jeweiliges Kontaktende des Kontaktelements an einer einzigen Stelle oder an einem einzigen Punkt als einzelnem Fußbereich für die Strom- und/oder Potenzialübertragung kontaktiert wird.

Bei einer alternativen oder zusätzlichen Fortentwicklung des Verfahrens zum Herstellen eines Leistungshalbleitermoduls ist es vorgesehen, dass ein jeweiliges Kontaktende des Kontaktelements an einer Mehrzahl Stellen oder an einer Mehrzahl Punkte als Mehrzahl Fußbereiche für die Strom- und/oder Potenzialübertragung kontaktiert wird.

Bei einer weiteren alternativen oder zusätzlichen Fortentwicklung des Verfahrens zum Herstellen eines Leistungshalbleitermoduls ist es vorgesehen, dass das jeweilige Kontaktelement als ein Element aus der Gruppe ausgebildet wird, die besteht aus Kontaktdrähten, Bonddrähten, Litzen und Stanzteilen.

Bei einer weiteren alternativen oder zusätzlichen Ausgestaltungsform des Verfahrens zum Herstellen eines Leistungshalbleitermoduls ist es vorgesehen, dass das Kontaktende und/oder der Kontakt mäanderförmig ausgebildet werden.

Der Kontaktbereich kann als Pad ausgebildet werden.

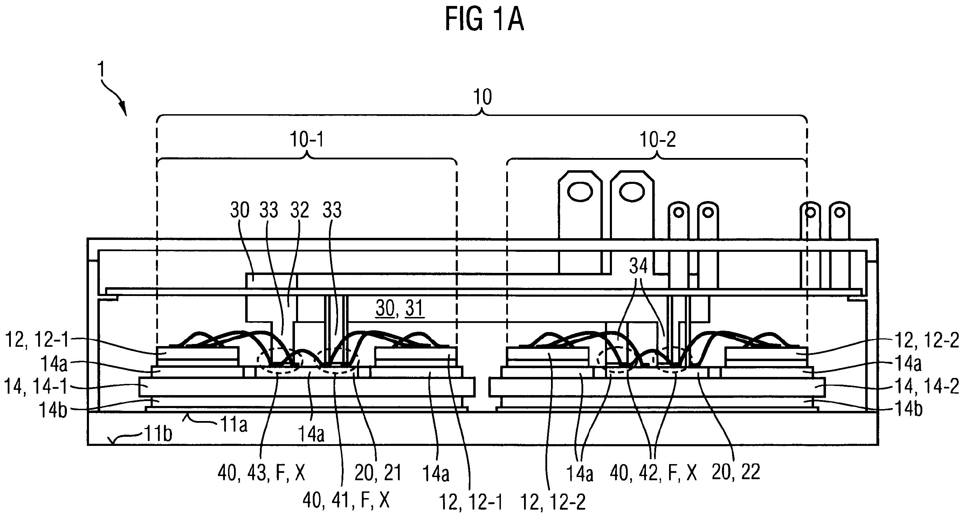

Fig. 1A ist eine schematische und geschnittene Seitenansicht einer ersten Ausführungsform des Leistungshalbleitermoduls 1, die nicht durch die beanspruchte Erfindung abgedeckt ist.

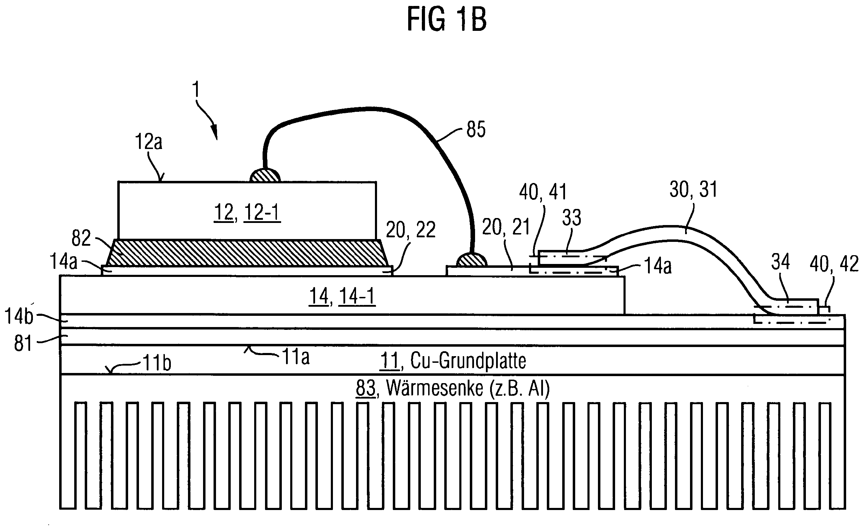

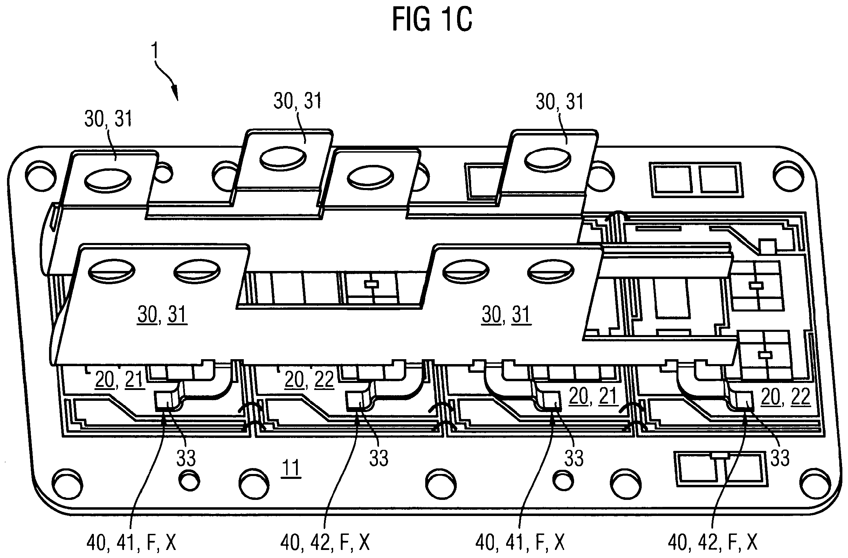

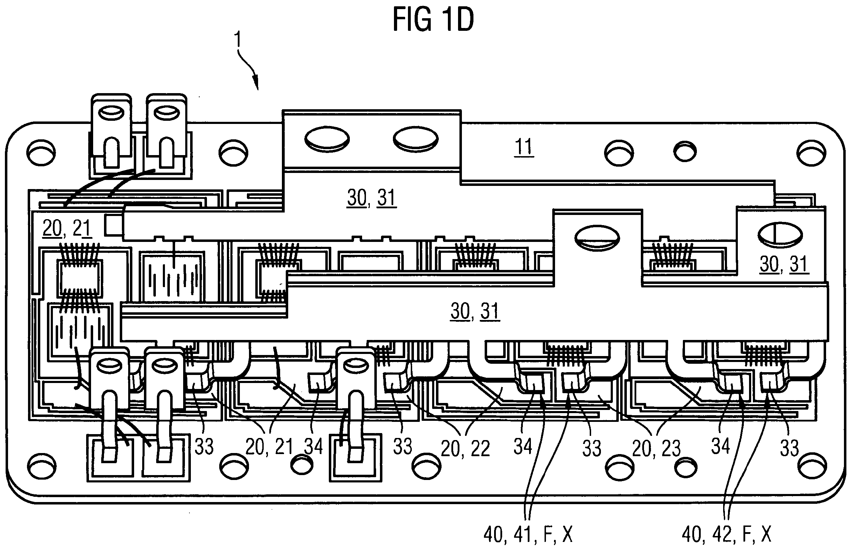

Die in Fig. 1A dargestellte Ausführungsform des Leistungshalbleitermoduls 1 basiert auf einem Träger 11, z.B. aus einer Kupfer-, Aluminium- oder MMC-Bodenplatte, welche eine Oberseite 11a und eine Unterseite 11b aufweist. Auf der Oberseite 11a des Trägers 11 sind in der in Fig. 1 dargestellten Ausführungsform zwei Substrate oder Substratbereiche 14, 14-1 und 14, 14-2 vorgesehen, die voneinander räumlich beabstandet sind. Die Substrate oder Substratbereiche 14, 14-1, 14-2 können Metall-Keramik-Metall-Kompositmaterialien sein, z.B. DCB-Substrate.

Das erste Substrat oder der erste Substratbereich 14-1 korrespondiert mit einem ersten Schaltungsbereich 10-1 der dem Leistungshalbleitermodul 1 zugrunde liegenden Halbleiterschaltung 10, und zwar über einen vorgesehenen ersten Halbleitermaterialbereich 12, 12-1 auf dessen Oberfläche 14a und einer darin ausgebildeten entsprechenden Baugruppe, die auch aus einem einzelnen Element bestehen kann, wogegen das zweite Substrat oder der zweite Substratbereich 14, 14-2 mit einem zweiten Schaltungsbereich 10-2 der dem Leistungshalbleitermodul 1 zugrunde liegenden Halbleiterschaltung 10 korrespondiert, und zwar über einen vorgesehenen zweiten Halbleitermaterialbereich 12, 12-1 auf dessen Oberfläche 14a und einer darin ausgebildeten entsprechenden Baugruppe.

Auf den Oberseiten 14a der ersten und zweiten Substratbereiche 14, 14-1 und 14, 14-2 sind metallische Bereiche in schaltungsgerechter Art und Weise ausgebildet. Die Unterseiten 14b der ersten und zweiten Substratbereiche 14, 14-1 und 14, 14-2 sind mit metallischen Bereichen durchmetallisiert und dienen ggf. der Kontaktierung und Anbringung auf der Oberseite 11a einer Bodenplatte 11.

Auf der Oberseite 14a der Substratbereiche 14-1 und 14-2 sind verschiedene Kontaktbereiche 20, z.B. in Form von Pads oder dergleichen, vorgesehen. Auf dem ersten Substratbereich 14-1 ist ein erster Kontaktbereich 21 ausgebildet. Auf dem zweiten Trägerbereich 14-2 sind zweite und dritte Kontaktbereiche 22 bzw. 23 ausgebildet.

Zur Kontaktierung der Halbleitermaterialbereiche12-1 und 12-2 und der entsprechenden Schaltungsbereiche 10-1 und 10-2 miteinander bzw. nach außen hin sind entsprechende Kontaktelemente 30 vorgesehen, die erste und zweite Kontaktenden 33 bzw. 34 aufweisen. So ist z.B. ein erstes Kontaktelement 31, hier in Form eines Stanzteiles als massive Stromabnahme, zur Kontaktierung der ersten und zweiten Schaltungsbereiche 10-1 und 10-2 über die ersten und zweiten Kontaktbereiche 21 bzw. 22 miteinander vorgesehen. Dabei ist das erste Kontaktende 33 des ersten Kontaktelements 31 mit dem ersten Kontaktbereich 21 auf dem ersten Substratbereich 14-1 elektrisch oder mechanisch kontaktiert, wogegen das zweite Ende 34 des ersten Kontaktelements 31 auf dem zweiten Kontaktbereich 22 auf dem zweiten Substratbereich 14-2 kontaktiert ist.

Auf diese Art und Weise werden jeweils Kontakte 40 gebildet, nämlich ein erster Kontakt 41 im Bereich des ersten Kontaktbereichs 21 mit dem ersten Kontaktende 33 des ersten Kontaktelements 31 auf der Oberfläche 14a des ersten Substratbereichs 14-1 und ein zweiter Kontakt 42 im Bereich des zweiten Kontaktbereichs 22 auf dem zweiten Substratbereich 12-2 unter Verwendung des zweiten Kontaktendes 34 des ersten Kontaktelements 31 auf der Oberfläche 14a des zweiten Substratbereichs 14-2.

Das bei der Ausführungsform der Fig. 1A vorgesehene zweite Kontaktelement 32 dient einer anderen Form der Kontaktierung des ersten Schaltungsbereichs 10-1, nämlich durch Ausbildung eines dritten Kontakts 43 im Bereich des ersten Kontaktbereichs 21 des ersten Substratbereichs 14-1, wobei das erste Kontaktende 33 des zweiten Kontaktelements 32 auf dem ersten Kontaktbereich 21 auf der Oberfläche 14a des ersten Substratbereichs 12-2 kontaktiert ist.

Die so ausgebildeten Kontakte 40 - 43 liegen als Ultraschallschweißkontakte vor.

Das Leistungshalbleitermodul 1 kann auch auf der Grundlage nur eines zusammenhängenden Halbleitermaterialbereichs 12 oder mit einer höheren Mehrzahl Halbleitermaterialbereiche 12 ausgebildet sein. Es können des Weiteren mehr oder weniger Kontaktbereiche 20 vorgesehen sein, als in der Fig. 1A dargestellt ist.

Die Figuren 1B bis 1D zeigen andere Ausführungsformen des Leistungshalbleitermoduls 1, die nicht durch die beanspruchte Erfindung abgedeckt sind, wobei die Kontaktelemente 30, 31, 32 jeweils als so genannte Stromabnahmen konzipiert sind und - bei den Ausführungsformen gemäß Fig. 1C und 1D - über eine Mehrzahl Kontaktenden 33, 34 auch eine Mehrzahl Kontakte 40, 41, 42, 43 realisieren können, wobei diese simultan ausgebildet werden können.

In Fig. 1B ist der Träger 11 als Grundplatte mit seiner Unterseite 11b auf einem Kühlkörper als Wärmesenke 83 angeordnet. Auf der Oberseite 11a des Trägers ist über eine erstes Lotmittel 81 der Substratbereich 14, 14-1, z.B. ein DCB- Substrat, vorgesehen, dessen Unterseite 14b eine durchgehende Metallisierung ist und dessen Oberseite 14a eine schaltungsgerecht strukturierte Metallisierung ist.

Auf der linken Seite der Oberseite 14a des Substratbereichs 14, 14-1 ist über eine zweites Lotmittel 82mit seiner Unterseite 12b eine Halbleitermaterialbereich 12, 12-1 oder Chip mit einer darin enthaltenen Halbleiterschaltung 10 vorgesehen. Die Oberseite 12a des Halbleitermaterialbereichs 12, 12-1 ist über einen Bonddraht 85 mit einem rechts angeordneten Teil der metallischen Oberseite 14a des Substratbereichs 14, 14-1 kontaktiert, durch welchen ein Kontaktbereich 20, 21 gebildet wird. Auf diesem Kontaktbereich 20, 21 ist über einen ersten Kontakt 40, 41 und ein erstes Kontaktende 33 ein Kontaktelement 30, 31 in Form einer massiven Stromabnahme angeschlossen und führt über ein zweites Kontaktende 34 zu einem zweiten Kontakt 40, 42, der von einem frei gelegten Teil der Metallisierung der Unterseite 14b des Substratbereichs 14, 14-1 gebildet wird.

Die Fig. 1C und 1D zeigen in perspektivischerDraufsicht zwei andere Ausführungsformen des Leistungshalbleitermoduls 1, wobei neben Kontaktelementen mit nur einem Kontaktende jeweils auch mehrere Kontaktelemente 30, 31, 32 in Form massiver Stromabnahmen mit jeweils einer Mehrzahl Kontaktenden 33, 34 zur Ausbildung einer Mehrzahl Kontakte 40 - 43 oder Fuß- punkte F an verschieden Stellen X vorgehen sind, die insbesondere simultan über fügendes Ultraschallschweißen ausgebildet werden.

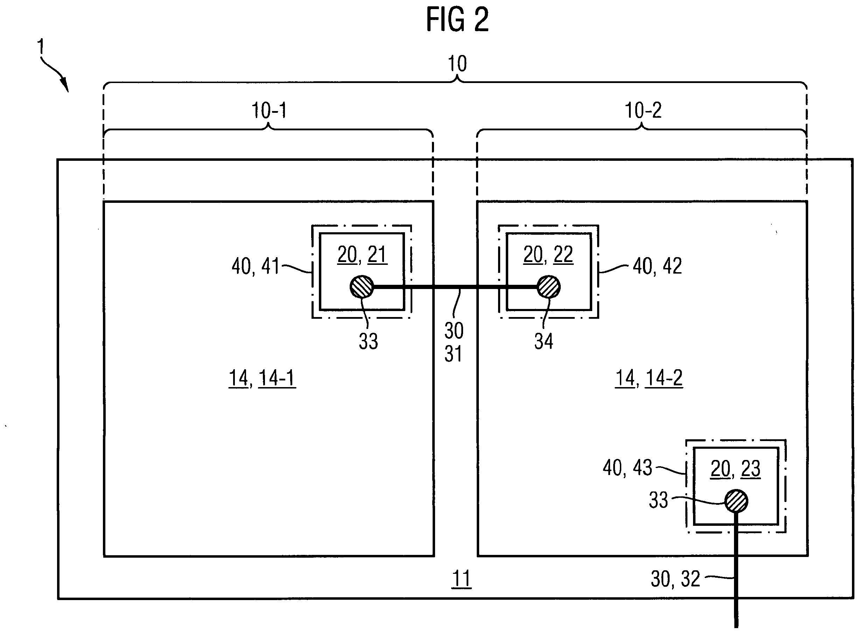

Fig. 2 ist eine schematische Draufsicht auf eine andere Ausführungsform des Leistungshalbleitermoduls 1, die nicht durch die beanspruchte Erfindung abgedeckt ist. Die einzelnen Schaltungsbereiche 10-1 und 10-2 sind hier nicht im Detail gezeigt, vielmehr wird auf die Kontaktbereiche 20, 21, 22, 23 auf den Substratbereichen 14, 14-1, 14-2 eingegangen.

Die in Fig. 2 dargestellte Ausführungsform des Leistungshalbleitermoduls 1 basiert wieder auf einem Träger 11, aus einer kupfernen Grundplatte, welche eine Oberseite 11a und eine Unterseite 11b aufweist. Auf der Oberseite 11a des Trägers 11 sind in der in Fig. 2 dargestellten Ausführungsform zwei Substratbereiche 14, 14-1, 14-2 vorgesehen, die voneinander räumlich beabstandet sind. Der erste Substratbereich 14-1 korrespondiert mit einem ersten Schaltungsbereich 10-1 der dem Leistungshalbleitermodul 1 zugrunde liegenden Halbleiterschaltung 10, wogegen der zweite Substratbereich 14-2 mit einem zweiten Schaltungsbereich 10-2 der dem Leistungshalbleitermodul 1 zugrunde liegenden Halbleiterschaltung 10 korrespondiert. Die Substratbereiche 14-1 und 14-2 besitzen ihrerseits eben- falls jeweils eine Oberseite 14a und eine Unterseite 14b. Somit ist jeweils die Unterseite 14b des jeweiligen Substratbereichs 14, 14-1, 14-2 auf der Oberseite 11a des zugrunde liegenden Trägers 11 aufgebracht.

Auf der Oberseite 14a der Substratbereiche 14-1 und 14-2 sind verschiedene Kontaktbereiche 20, z.B. in Form von Pads oder dergleichen, vorgesehen. Auf dem ersten Substratbereich 14-1 ist ein erster Kontaktbereich 21 ausgebildet. Auf dem zweiten Substratbereich 14-2 sind zweite und dritte Kontaktbereiche 22 bzw. 23 ausgebildet.

Zur Kontaktierung der Substratbereiche 14-1 und 14-2 und ggf. der entsprechenden Schaltungsbereiche 10-1 und 10-2 nach außen hin sind entsprechende Kontaktelemente 30 vorgesehen, die erste und zweite Kontaktenden 33 bzw. 34 aufweisen. So ist z.B. ein erstes Kontaktelement 31 zur Kontaktierung der ersten und zweiten Substratbereiche 14-1 und 14-2 über die ersten und zweiten Kontaktbereiche 21 bzw. 22 miteinander vorgesehen. Dabei ist das erste Kontaktende 33 des ersten Kontaktelements 31 mit dem ersten Kontaktbereich 21 auf dem ersten Substratbereich 14-1 elektrisch und mechanisch kontaktiert, wogegen das zweite Ende 34 des ersten Kontaktelements 31 auf dem zweiten Kontaktbereich 22 auf dem zweiten Substratbereich 14-2 kontaktiert ist. Auf diese Art und Weise werden wieder Kontakte 40 gebildet, nämlich ein erster Kontakt 41 im Bereich des ersten Kontaktbereichs 21 mit dem ersten Kontaktende 33 des ersten Kontaktelements 31 auf dem ersten Substratbereich 14-1 und ein zweiter Kontakt 42 im Bereich des zweiten Kontaktbereichs 22 auf dem zweiten Substratbereich 14-2 unter Verwendung des zweiten Kontaktendes 34 des ersten Kontaktelements 31.

Das bei der Ausführungsform der Fig. 2 vorgesehene zweite Kontaktelement 32 dient der externen Kontaktierung der gesamten Halbleiterschaltung 10, nämlich durch Ausbildung eines dritten Kontakts 43 im Bereich des dritten Kontaktbereichs 23 des zweiten Substratbereichs 12-2, wobei das erste Kontakten- de 33 des zweiten Kontaktelements 32 auf dem dritten Kontaktbereich 23 auf der Oberfläche 14a des zweiten Substratbereichs 14-2 kontaktiert ist. Das zweite Kontaktelement 32 verläuft dann vom eigentlichen Leistungshalbleitermodul 1 fort nach extern.

Die Kontakte 40 - 43 werden wieder als Ultraschallschweißkontakte ausgebildet.

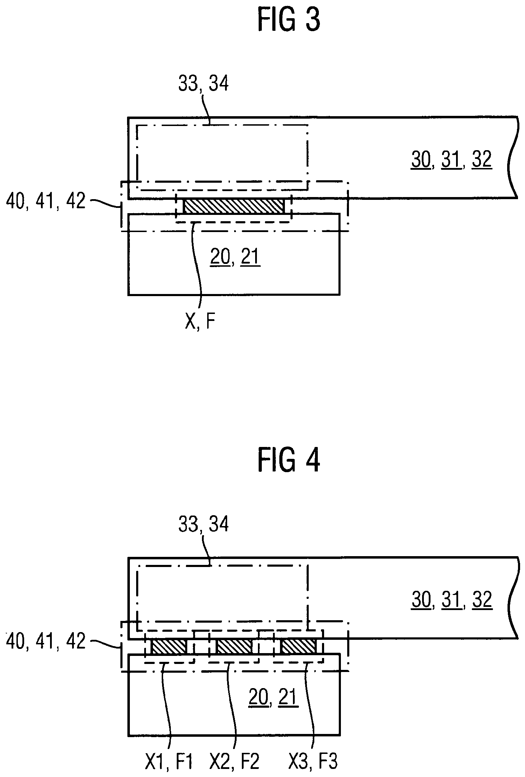

Fig. 3 zeigt in schematischer und geschnittener Seitenansicht die durch Ultraschallschweißung ausgebildeten Kontakte 40 - 43 zwischen einem Kontaktelement 30 - 32 und einem Kontaktbereich 20 - 22. Bei der Ausführungsform der Fig. 3, die nicht durch die beanspruchte Erfindung abgedeckt ist, wird dabei durch Ultraschallschweißung an einer einzelnen und einzigen Stelle X zwischen dem ersten oder zweiten Kontaktende 32 bzw. 34 des Kontaktelements 30 - 32 ein einziger Fußbereich F für die Übertragung von Strom und/oder Potenzial ausgebildet.

Bei der Ausführungsform der Fig. 4, die nicht durch die beanspruchte Erfindung abgedeckt ist, dagegen werden durch Ultraschallschweißung bei der Herstellung der Kontakte 40 - 42 an mehreren Punkten oder Stellen, nämlich an drei Punkten oder Stellen X1, X2 und X3, eine entsprechende Mehrzahl Fußbereiche F1, F2 und F3 für die Übertragung von elektrischem Strom und/oder elektrischem Potenzial ausgebildet.

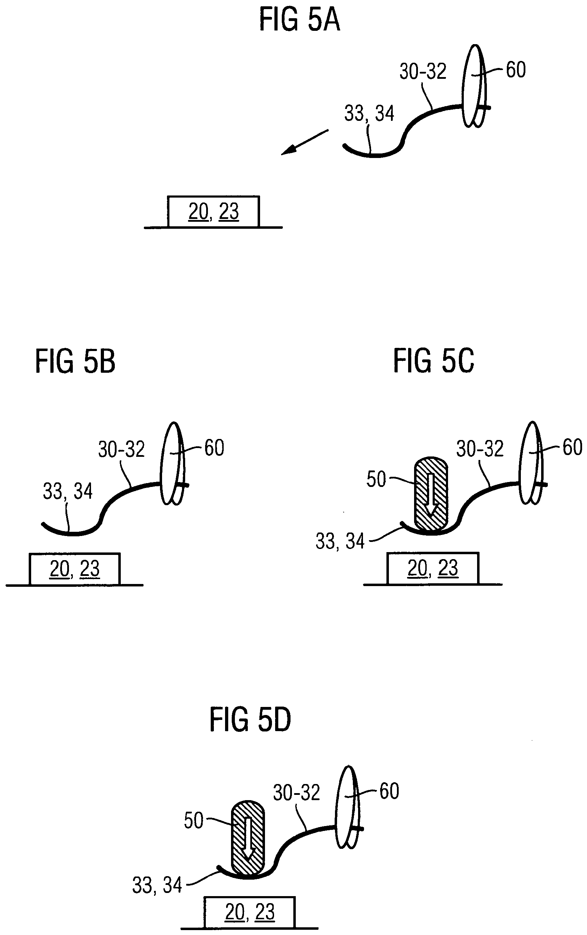

Die Fig. 5A bis 5D zeigen in schematischer und geschnittener Seitenansicht Zwischenstufen, die bei einer Ausführungsform des Verfahrens zum Herstellen eines Leistungshalbleitermoduls, die nicht durch die beanspruchte Erfindung abgedeckt ist, erreicht werden.

Wie in Fig. 5A dargestellt ist, wird zunächst ein Kontaktelement 30 - 32 bereitgestellt, z.B. in Form eines Stanzteils oder in Form eines Bonddrahts oder dergleichen. Dazu wird das Kontaktelement 30 - 32 mittels einer Halte- und Positioniervorrichtung 60 ergriffen und durch Positionieren entsprechend an einen Kontaktbereich 20 - 23 herangeführt.

Dadurch wird der in Fig. 5B gezeigte Zwischenzustand erreicht, bei welchem das Kontaktelement 30 - 32 derart positioniert ist, dass das entsprechende Kontaktende 33, 34 des Kontaktelements 30 - 32 kurz oberhalb des Kontaktbereichs 20 - 23 angeordnet ist, dieses mit dem Kontaktende 33, 34 aber nicht unbedingt zu berühren braucht.

Im Übergang zu dem in Fig. 5C gezeigten Zwischenzustand wird dann unter unveränderter Positionierung des Kontaktelements 30 - 32 mittels der Halte- und Positioniervorrichtung 60 eine Sonotrode SO an das Kontaktende 33, 34 des Kontaktelements 30 - 32 derart herangeführt, dass dadurch ein Bereich des Kontaktendes 33, 34 berührt und unter Kraftaufwand oder durch Druck, die durch den weißen Pfeil dargestellt sind, auf den Kontaktbereich 20 - 23 zu bewegt wird.

Dies geschieht in einer Art und Weise, dass sich der in Fig. 5D gezeigte Zwischenzustand einstellt, bei welchem durch den Kraftaufwand oder unter Druck durch die Sonotrode SO das Kontaktende 33, 34 des Kontaktelements 30 - 32 in mechanischem und elektrischem Kontakt mit der Oberfläche des Kontaktbereichs 20 - 23 steht. In dem in Fig. 5D gezeigten Zwischenzustand wird dann auch die Sonotrode SO zum Ultraschallschweißen aktiviert, um dann den entsprechenden Kontakt 40 - 43 zwischen dem Kontaktbereich 20 - 23 und dem Kontaktende 33, 34 als Ultraschallschweißkontakte auszubilden.

Das gemäß den Fig. 5A bis 5D dargestellte Vorgehen hat den Vorteil, dass sämtliche Formen von Kontaktelementen 30 - 32 verarbeitet und kontaktiert werden können.

Es kann sich dabei um Kontaktelemente 30 - 32 handeln, die eine externe Kontaktierung eines Halbleitermoduls 1 nach außen realisieren und somit nur mit einem einzigen Kontaktende 33 im Bereich der Halbleiterschaltungsanordnung 10 kontaktiert werden oder sind. Es kann sich aber auch um interne Kontaktelemente 30, 31 handeln, die unterschiedliche Halbleiterschaltungsbereiche 10-1 und 10-2 innerhalb eines Gehäuses des Moduls miteinander kontaktieren.

Im Gegensatz zu bekannten Herstellungsverfahren ist hier also eine externe Fixierung der zu kontaktierenden Kontaktelemente 30 - 32, z.B. im Bereich eines Gehäuserahmens oder im Bereich einer Vergussmasse, nicht notwendig. Dies ergibt sich aus dem Umstand, dass hier die Sonotrode 50 selbst zur mechanischen Endpositionierung der Kontaktenden 33, 34 durch Andruck auf die Oberfläche der zu kontaktierenden Kontaktbereiche 20 - 23 eingesetzt wird, wobei gleichzeitig also ein entsprechender Fügeprozess zwischen den zu fügenden Einzelteilen, nämlich den Kontaktelementen 30 - 32 einerseits und den Kontaktbereichen 20 - 23 andererseits, erfolgt.

## Patentansprüche

1. Verfahren zum Herstellen eines Leistungshalbleitermoduls (1),
- bei welchem eine Leistungshalbleiterschaltung (10) zu deren elektrischer Kontaktierung mit mindestens einem ersten Kontaktbereich (20 - 23) ausgebildet wird,
- bei welchem zur elektrischen Kontaktierung der Leistungshalbleiterschaltung (10) ferner ein Kontaktelement (30 - 32) mit mindestens einem ersten Kontaktende (33, 34) ausgebildet wird,
- bei welchem mindestens das erste Kontaktende (33, 34) mit dem ersten Kontaktbereich (20 - 23) zu einem ersten Kontakt (40 - 43) mechanisch und elektrisch mittels Ultraschallschweißen verbunden wird,
- indem eine Sonotrode (50), die für den Ultraschallschweißvorgang verwendet wird, auch zum Fügen der Kontaktenden (33, 34) mit den Kontaktbereichen (20-23) und mithin zum Fügen der Kontakte (40, 42) verwendet wird, wobei als Kontaktelemente (30 - 32) massive kupferne oder primär Kupfer enthaltende Stromabnahmen verwendet werden mit einer Materialstärke im Bereich von etwa 0,1 mm bis etwa 3,0 mm und mit einer Stromtragfähigkeit im Bereich von etwa 50 A bis etwa 2000 A,
- wobei zumindest ein Teil der Kontaktbereiche (20-23) von einem DCB-Substrat mit einer kupfernen oder primär Kupfer enthaltenden Schicht mit einer Materialstärke im Bereich von etwa 0,1 mm bis etwa 1,0 mm gebildet wird,
- wobei eine Ultraschallschweißleistung im Bereich von etwa 300 W bis etwa 10 kW verwendet wird,
- wobei als Fügekraft eine Normalkraft auf oder für die Sonotrode im Bereich von etwa 500 N bis etwa 3500 N verwendet wird;
- bei welchem vor dem eigentlichen Ultraschallschweissvorgang die Sonotrode (50) auf den Kontaktbereich (20-23) abgesenkt wird, so dass dadurch das jeweilige Kontaktende (33, 34) unter Kraft oder Druck auf die Oberfläche (20a) des jeweiligen Kontaktbereichs (20 - 22) angedrückt wird, und die Sonotrode (50) erst nach dem Andrücken des jeweiligen Kontaktendes (33, 34) an den Kontaktbereich (20-23) aktiviert wird; und
- bei welchem in der Nachbarschaft zu Kantenbereichen der Kontaktbereiche (20 - 23) beim Ultraschallschweißen eine Schweißrichtung und/oder Schwingungsrichtung verwendet wird, die im Wesentlichen parallel zur Richtung des jeweiligen Kantenbereichs verläuft, um ein Ablösen des Kontaktbereichs (20 - 23) am DCB-Substrat zu vermeiden.

2. Verfahren nach Anspruch 1,
wobei Stromabnahmen verwendet werden mit wenigstens einem von:
einer Materialstärke im Bereich von etwa 0,8 mm bis etwa 1,5 mm, und
einer Stromtragfähigkeit im Bereich von etwa 300 A bis etwa 2000 A, vorzugsweise im Bereich von etwa 300 A bis etwa 1000 A

3. Verfahren nach einem der vorangehenden Ansprüche, wobei ein DCB-Substrat mit einer kupfernen oder primär Kupfer enthaltenden Schicht mit einer Materialstärke im Bereich von etwa 0,25 mm bis etwa 0,6 mm verwendet wird.

4. Verfahren nach einem der vorangehenden Ansprüche,
wobei wenigstens eines von:
die Ultraschallschweißleistung im Bereich von etwa 500 W bis etwa 2 kW liegt, und
die Energie für das Ultraschallschweißen im Bereich von etwa 50 Ws bis etwa 3 kWs liegt, vorzugsweise im Bereich von etwa 50 Ws bis etwa 800 Ws.

5. Verfahren nach einem der vorangehenden Ansprüche,
wobei wenigstens eines von:
die Frequenz für das Ultraschallschweißen im Bereich von etwa 20 kHz bis etwa 35 kHz liegt, und
die Amplitude für das Ultraschallschweißen im Bereich von etwa 15 µm bis etwa 50 µm liegt, vorzugsweise im Bereich von etwa 25 µm bis etwa 35 µm.

6. Verfahren nach einem der vorangehenden Ansprüche,
wobei die Schweißzeit für das Ultraschallschweißen im Bereich von etwa 50 ms bis etwa 2000 ms liegt, vorzugsweise im Bereich von etwa 100 ms bis etwa 500 ms.

7. Verfahren nach einem der vorangehenden Ansprüche, wobei die ersten Kontaktenden (33, 34) der Kontaktelemente (30 - 32) mit Energierichtungsgebern in Form von Erhebungen an den ersten Kontaktenden (33, 34) zur besseren Kraftausrichtung beim Ultraschallschweißen ausgebildet werden.

8. Verfahren nach Anspruch 7,
wobei die Energierichtungsgeber wenigstens eines aufweisen von:
eine Materialstärke im Bereich von etwa 0,05 mm bis etwa 0,50 mm, vorzugsweise im Bereich von etwa 0,10 mm bis etwa 0,20 mm,
einen Durchmesser im Bereich von etwa 0,5 mm bis etwa 4,0 mm, vorzugsweise im Bereich von etwa 1,0 mm bis etwa 1,5 mm, und
eine Fläche im Bereich von etwa 0,2 mm² bis etwa 12,5 mm², vorzugsweise im Bereich von etwa 0,8 mm² bis etwa 1,8 mm².

9. Verfahren nach einem der vorangehenden Ansprüche,
bei welchem das Ultraschallschweißen als simultaner Mehrfachschweißvorgang durchgeführt wird, bei welchem simultan eine Mehrzahl Kontaktelemente (30 - 32) über eine Mehrzahl Kontaktenden (33, 34) kontaktiert werden, insbesondere mit jeweils einer Stromtragfähigkeit im Bereich von etwa 50 A bis etwa 500 A.

10. Verfahren nach einem der vorangehenden Ansprüche,
bei welchem ein jeweiliges Kontaktelement (30-32) zunächst mittels einer Halte- und Positioniervorrichtung (60) gehaltert und positioniert wird und dann mittels der Sonotrode (50) das Fügen und Fixieren erfolgt.

11. Verfahren nach einem der vorangehenden Ansprüche,
bei welchem
entweder das jeweilige Kontaktende (33, 34) des Kontaktelements (30 - 32) an einer Stelle (X) oder an einem Punkt (X) als einzelnem Fußbereich (F) für die Strom- und/oder Potenzialübertragung kontaktiert wird, oder
das jeweilige Kontaktende (33, 34) des Kontaktelements (30 - 32) an einer Mehrzahl Stellen (Xl - X3) oder an einer Mehrzahl Punkte (Xl - X3) als Mehrzahl Fußbereiche (Fl - F3) für die Strom- und/oder Potenzialübertragung kontaktiert wird.

12. Verfahren nach einem der vorangehenden Ansprüche,
bei welchem:
das jeweilige Kontaktelement (30 - 32) als ein Element aus der Gruppe ausgebildet wird, die besteht aus Kontaktdrähten, Bonddrähten, Litzen und Stanzteilen.

13. Verfahren nach einem der vorangehenden Ansprüche,
bei welchem wenigstens eines von:
das Kontaktende (33, 34) und/oder der Kontakt (41 - 43) mäanderförmig ausgebildet werden, und
der Kontaktbereich (20 - 23) als Pad ausgebildet wird.

## Claims

1. Method for producing a power semiconductor module (1),
- in which a power semiconductor circuit (10) is formed with at least one first contact region (20-23) for making electrical contact with said circuit,
- in which a contact element (30-32) with at least one first contact end (33, 34) is furthermore formed for making electrical contact with the power semiconductor circuit (10),
- in which at least the first contact end (33, 34) is mechanically and electrically connected to the first contact region (20-23) to form a first contact (40-43) by means of ultrasonic welding,
- by virtue of a sonotrode (50) that is used for the ultrasonic welding operation also being used for joining the contact ends (33, 34) with the contact regions (20-23) and consequently for joining the contacts (40, 42), wherein solid copper or primarily copper-containing current taps are used as contact elements (30-32), having a material thickness within the range of approximately 0.1 mm to approximately 3.0 mm and having a current-carrying capacity within the range of approximately 50 A to approximately 2000 A,
- wherein at least some of the contact regions (20-23) are formed by a DCB substrate with a copper or primarily copper-containing layer having a material thickness within the range of approximately 0.1 mm to approximately 1.0 mm,
- wherein an ultrasonic welding power within the range of approximately 300 W to approximately 10 kW is used, and
- wherein a normal force to or for the sonotrode within the range of approximately 500 N to approximately 3500 N is used as joining force;
- in which, prior to the actual ultrasonic welding operation, the sonotrode (50) is lowered onto the contact region (20-23), such that the respective contact end (33, 34) is thereby pressed under force or pressure onto the surface (20a) of the respective contact region (20-22), and the sonotrode (50) is activated only after the respective contact end (33, 34) has been pressed onto the contact region (20-23); and
- in which, in the vicinity of edge regions of the contact regions (20-23), during ultrasonic welding, a welding direction and/or vibration direction is used which runs essentially parallel to the direction of the respective edge region in order to avoid detachment of the contact region (20-23) at the DCB substrate.

2. Method according to Claim 1,
wherein current taps are used having at least one of:
a material thickness within the range of approximately 0.8 mm to approximately 1.5 mm, and
a current-carrying capacity within the range of approximately 300 A to approximately 2000 A, preferably within the range of approximately 300 A to approximately 1000 A.

3. Method according to any of the preceding claims, wherein a DCB substrate with a copper or primarily copper-containing layer having a material thickness within the range of approximately 0.25 mm to approximately 0.6 mm is used.

4. Method according to any of the preceding claims, wherein at least one of the following applies:
the ultrasonic welding power lies within the range of approximately 500 W to approximately 2 kW, and
the energy for the ultrasonic welding lies within the range of approximately 50 Ws to approximately 3 kWs, preferably within the range of approximately 50 Ws to approximately 800 Ws.

5. Method according to any of the preceding claims, wherein at least one of the following applies:
the frequency for the ultrasonic welding lies within the range of approximately 20 kHz to approximately 35 kHz, and
the amplitude for the ultrasonic welding lies within the range of approximately 15 µm to approximately 50 µm, preferably within the range of approximately 25 µm to approximately 35 µm.

6. Method according to any of the preceding claims, wherein the welding time for the ultrasonic welding lies within the range of approximately 50 ms to approximately 2000 ms, preferably within the range of approximately 100 ms to approximately 500 ms.

7. Method according to any of the preceding claims, wherein the first contact ends (33, 34) of the contact elements (30-32) are formed with energy direction indicators in the form of elevations at the first contact ends (33, 34) for better force alignment during ultrasonic welding.

8. Method according to Claim 7,
wherein the energy direction indicators have at least one of:
a material thickness within the range of approximately 0.05 mm to approximately 0.50 mm, preferably within the range of approximately 0.10 mm to approximately 0.20 mm,
a diameter within the range of approximately 0.5 mm to approximately 4.0 mm, preferably within the range of approximately 1.0 mm to approximately 1.5 mm, and
an area within the range of approximately 0.2 mm² to approximately 12.5 mm², preferably within the range of approximately 0.8 mm² to approximately 1.8 mm².

9. Method according to any of the preceding claims,
wherein the ultrasonic welding is carried out as a simultaneous multiple welding operation, in which a plurality of contact elements (30-32) are simultaneously contact-connected via a plurality of contact ends (33, 34), in particular with a respective current-carrying capacity within the range of approximately 50 A to approximately 500 A.

10. Method according to any of the preceding claims,
in which a respective contact element (30-32) is firstly held and positioned by means of a holding and positioning device (60) and the joining and fixing are then effected by means of the sonotrode (50).

11. Method according to any of the preceding claims,
in which
either the respective contact end (33, 34) of the contact element (30-32) is contact-connected at one location (X) or at one point (X) as individual foot region (F) for the current and/or potential transmission, or
the respective contact end (33, 34) of the contact element (30-32) is contact-connected at a plurality of locations (X1-X3) or at a plurality of points (X1-X3) as a plurality of foot regions (F1-F3) for the current and/or potential transmission.

12. Method according to any of the preceding claims,
in which:
the respective contact element (30-32) is formed as an element from the group consisting of contact wires, bonding wires, litz wires and stamped parts.

13. Method according to any of the preceding claims, in which at least one of the following applies:
the contact end (33, 34) and/or the contact (41-43) are formed in meandering fashion, and
the contact region (20-23) is formed as a pad.

## Revendications

1. Procédé de fabrication d'un module (1) à semiconducteur de puissance,
- dans lequel on constitue un circuit (10) à semiconducteur de puissance pour sa mise en contact électrique par au moins une première partie (20 à 23) de contact,
- dans lequel on constitue pour la mise en contact électrique du circuit (10) à semiconducteur de puissance en outre un élément (30 à 32) de contact ayant au moins une première extrémité (33, 34) de contact,
- dans lequel on relie mécaniquement et électriquement au moyen d'une soudure par ultrasons la première extrémité (33, 34) de contact à la première partie (20 à 23) de contact en un premier contact (40 à 43),
- dans lequel on utilise une sonotrode (50), que l'on utile pour l'opération de soudure par ultrasons, également pour la jonction des extrémités (33, 34) de contact aux parties (20 à 23) de contact et partant pour la jonction des contacts (40, 42), dans lequel on utilise comme élément (30 à 32) de contact des prises de courant en cuivre massif ou en contenant principalement en une épaisseur de matériau dans la plage d'environ 0,1 mm à environ 3,0 mm et avec une aptitude à porter le courant dans la plage d'environ 50 A à environ 2 000 A,
- dans lequel on forme au moins une partie des parties (20 à 23) de contact d'un substrat DCB ayant une couche cuivrée ou contenant principalement du cuivre en une épaisseur de matériau dans la plage d'environ 0,1 mm à environ 1,0 mm,
- dans lequel on utilise une puissance de soudure par ultrasons dans la plage d'environ 300 W à environ 10 kW,
- dans lequel on utilise comme force de jonction une force normale sur ou pour la sonotrode dans la plage d'environ 500 N à environ 3500 N ;
- dans lequel avant l'opération de soudure par ultrasons proprement dite, on abaisse la sonotrode (50) sur la partie (20 à 23) de contact de manière à presser ainsi l'extrémité (33, 34) respective de contact avec force ou pression sur la surface (20a) de la partie (20 à 22) respective de contact et on active la sonotrode (50) seulement après avoir pressé l'extrémité (33, 34) respective de contact sur la partie (20 à 23) de contact ; et
- dans lequel, au voisinage des parties de bord des parties (20 à 23) de contact, on utilise lors de la soudure par ultrasons une direction de soudure et/ou une direction d'oscillation qui est sensiblement parallèle à la direction de la partie de bord respective afin d'empêcher que la partie (20 à 23) de contact ne se détache du substrat DCB.

2. Procédé suivant la revendication 1,
dans lequel on utilise des prises de courant ayant au moins l'une de :
une épaisseur de matériau dans la plage d'environ 0,8 mm à environ 1,5 mm, et
une aptitude à porter le courant dans la plage d'environ 300 A à environ 2 000 A, de préférence dans la plage d'environ 300 A à environ 1 000 A.

3. Procédé suivant l'une des revendications précédentes,
dans lequel on utilise un substrat DCB ayant une couche cuivrée ou contenant du cuivre principalement en une épaisseur de matériau dans la plage d'environ 0,25 mm à environ 0,6 mm.

4. Procédé suivant l'une des revendications précédentes,
dans lequel on a au moins l'un de :
la puissance de la soudure par ultrasons est dans la plage d'environ 500 W à environ 2 kW, et
l'énergie pour la soudure par ultrasons est dans la plage d'environ 50 W à environ 3 kW, de préférence dans la plage d'environ 50 W à environ 800 W.

5. Procédé suivant l'une des revendications précédentes,
dans lequel on a au moins l'une de :
la fréquence pour la soudure par ultrasons est dans la plage d'environ 20 kHz à environ 35 kHz, et
l'amplitude par la soudure par ultrasons est dans la plage d'environ 15 µm à environ 50 µm, de préférence dans la plage d'environ 25 µm à environ 35 µm.

6. Procédé suivant l'une des revendications précédentes,
dans lequel le temps de soudure pour la soudure par ultrasons est dans la plage d'environ 50 ms à environ 2 000 ms, de préférence dans la plage d'environ 100 ms à environ 500 ms.

7. Procédé suivant l'une des revendications précédentes,
dans lequel on constitue les premières extrémités (33, 34) de contact des éléments (30 à 32) de contact avec des donneurs de direction d'énergie sous la forme de surélévations sur les premières extrémités (33, 34) de contact pour une orientation meilleure de la force lors de la soudure par ultrasons.

8. Procédé suivant la revendication 7,
dans lequel les donneurs de direction d'énergie on au moins l'un de :
une épaisseur de matériau dans la plage d'environ 0,05 mm à environ 0,50 mm, de préférence dans la plage d'environ 0,10 mm à environ 0,20 mm,
un diamètre dans la plage d'environ 0,5 mm à environ 4,0 mm, de préférence dans la plage d'environ 1,0 mm à environ 1,5 mm, et
une surface dans la plage d'environ 0,2 mm² à environ 12,5 mm², de préférence dans la plage d'environ 0,8 mm² à environ 1,8 mm².

9. Procédé suivant l'une des revendications précédentes,
dans lequel on effectue la soudure par ultrasons sous la forme d'une opération de soudures multiples de manière simultanée, dans laquelle on met en contact simultanément une pluralité d'éléments (30 à 32) de contact sur une pluralité d'extrémités (33, 34) de contact, ayant notamment respectivement une aptitude à porter le courant dans la plage d'environ 50 A à environ 500 A.

10. Procédé suivant l'une des revendications précédentes,
dans lequel on maintient et on met en position un élément (30 à 32) respectif de contact d'abord au moyen d'un dispositif (60) de maintien et de mise en position et on effectue ensuite la jonction et la fixation au moyen de la sonotrode (50).

11. Procédé suivant l'une des revendications précédentes,
dans lequel
ou bien on met en contact l'extrémité (33, 34) respective de contact de l'élément (30 à 32) de contact en un point (X) ou en un point (X) comme partie (F) de pied individuel pour la transmission de courant et/ou de potentiel,
ou bien on met en contact l'extrémité (33, 34) respective de contact de l'élément (30 à 32) de contact en une pluralité de points (X1 à X3) ou en une pluralité de points (X1 à X3) comme pluralité de parties (F1 à F3) de pied pour la transmission de courant et/ou de potentiel.

12. Procédé suivant l'une des revendications précédentes,
dans lequel :
on constitue l'élément (30 à 32) respectif de contact sous la forme d'un élément choisi dans le groupe constitué de fils de contact, de fils de liaison, de cordons et de pièces découpées.

13. Procédé suivant l'une des revendications précédentes,
dans lequel on a au moins l'un de :
on constitue l'extrémité (33, 34) de contact et/ou le contact (41 à 43) sinueusement, et
on constitue la partie (20 à 23) de contact sous la forme d'une plage.
